# EUROPEAN PATENT APPLICATION

(11) **EP 4 793 978 A1**
(43) Date of publication of application: **19.08.2026**
(21) Application number: 25793235.0
(22) Date of filing: 27.02.2025
(51) Int. Cl.: H01F 27/24

(54) **TRANSFORMER AND CIRCUIT BOARD STRUCTURE**

(30) Priority: 26.04.2024 CN 202420885253 U
(71) Applicant: Shanghai Moorewatt Energy Technology Co., Ltd., Shanghai 200131 (CN)
(72) Inventor: CHEN, Junhao, Shanghai 200131 (CN)
(74) Representative: Zacco Sweden AB
(86) International application number: PCT/CN2025/079582
(87) International publication number: WO 2025/223037

(57) **Abstract**

The present disclosure relates to a transformer and a circuit board structure. The transformer includes: a magnetic core and a conductive member, wherein the magnetic core includes a base, a first surface of the base is provided with a first protruding member, and an outer side of the first protruding member is provided with a groove; and the conductive member is at least partially located in the groove and is electrically connected to the first protruding member. When eddy currents are generated on the magnetic core of the transformer due to a change in magnetic flux, the eddy currents can be led out from the conductive member, so as to eliminate an extra current on the magnetic core, avoiding vibration of the magnetic core, and thus eliminating noise.

## Description

### CROSS-REFERENCE TO RELATED APPLICATIONS

The present disclosure claims priority to Chinese patent application No. 2024208852530, filed on April 26, 2024, and entitled "TRANSFORMER AND CIRCUIT BOARD STRUCTURE", the entire content of which is incorporated herein by reference.

### TECHNICAL FIELD

The present disclosure relates to the field of power electronics technologies, and in particular, to a transformer and a circuit board structure.

### BACKGROUND

A transformer is an electrical device for changing an alternating current voltage, which achieves voltage transformation between input and output based on the principle of electromagnetic induction. The transformer typically includes two or more windings disposed on a magnetic core. According to a turns ratio of the transformer (i.e., a ratio of a number of turns of a primary winding to a number of turns of a secondary winding), an input voltage can be stepped up or down to a required output voltage level.

During operation, the transformer generates high-frequency electromagnetic wave noise in the magnetic core, causing the transformer to act as a noise signal source that radiates electromagnetic waves outward, resulting in adverse effects.

### SUMMARY

In view of the problem that the transformer radiates noise outward, it is necessary to provide a transformer and a circuit board structure.

In a first aspect, a transformer is provided in the present disclosure, including a magnetic core and a conductive member. The magnetic core includes a base. A first protruding member is disposed on a first surface of the base, and a groove is provided on an outer side of the first protruding member. The conductive member is at least partially located in the groove and is electrically connected to the first protruding member.

In some embodiments, the conductive member is at least partially fixed in the groove by a conductive connecting member.

In some embodiments, the conductive member has a bent portion, and a position of the conductive connecting member corresponds to the bent portion of the conductive member.

In some embodiments, the conductive connecting member is located at an end portion of the groove.

In some embodiments, the conductive connecting member is a metal sheet, and the conductive member is fixed in the groove by the metal sheet.

In some embodiments, the groove is cylindrical or square.

In some embodiments, in a thickness direction of the first protruding member, a ratio of a depth of the groove to a thickness of the first protruding member is less than a preset ratio threshold.

In some embodiments, a length of the groove in a protruding direction of the first protruding member is less than a length of the first protruding member.

In some embodiments, the first protruding member is provided with a first opening, and the groove is provided at a preset distance from the first opening.

In some embodiments, the transformer further includes a fixing member disposed at the first opening. A first part of the fixing member is located inside the first protruding member, and a second part of the fixing member is located outside the first protruding member.

In some embodiments, the second part of the fixing member is provided with a second opening, and an end of the conductive member passes through the second opening.

In a second aspect, a transformer is further provided in the present disclosure, including a first magnetic core, a second magnetic core and a conductive member. A through groove is provided on an outer side of a first protruding member of the first magnetic core, and the conductive member is at least partially located in the through groove and abuts against a second protruding member of the second magnetic core.

In some embodiments, the conductive member is at least partially fixed in the groove by a conductive connecting member, and the conductive connecting member bridges across the first magnetic core and the second magnetic core.

In a third aspect, a circuit board structure is further provided in the present disclosure, including a circuit board and the transformer as described above. The circuit board is provided with a first circuit and a second circuit, and either or both of the first circuit and the second circuit include a switching device. The transformer is disposed on the circuit board, a first accommodating space and a second accommodating space are provided inside the first protruding member, the first accommodating space is provided with a first winding, the second accommodating space is provided with a second winding, the first winding is electrically connected to the first circuit, the second winding is electrically connected to the second circuit, and the conductive member is electrically connected to a stable potential of the circuit board.

In some embodiments, the stable potential is a ground potential on the circuit board.

In some embodiments, the stable potential is any one of the following: a positive terminal or a negative terminal of a power supply in the first circuit; a neutral wire or a live wire in the second circuit; and an intermediate potential formed by interconnecting filter capacitors in the first circuit or the second circuit.

In the above transformer and circuit board structure, the transformer includes a magnetic core and a conductive member. A groove is provided on the magnetic core. The conductive member is at least partially located in the groove and is electrically connected to the magnetic core. When the conductive member is connected to an external circuit to form a circuit loop, a current generated in the magnetic core of the transformer is introduced into the circuit loop instead of existing in a form of eddy current, thereby eliminating electromagnetic radiation of the magnetic core, reducing electromagnetic interference to other electronic devices, and eliminating noise.

### BRIEF DESCRIPTION OF THE DRAWINGS

To describe the technical solutions in the embodiments of the present disclosure or in the conventional technology more clearly, the following briefly introduces the accompanying drawings required for describing the embodiments or the conventional technology. Apparently, the accompanying drawings in the following description show merely part of the embodiments of the present disclosure, and those skilled in the art may obtain other drawings from these accompanying drawings without creative efforts.
FIG. 1 is a schematic diagram illustrating a structure of a transformer in conventional technology.
FIG. 2 is a schematic diagram illustrating a structure of a transformer in some embodiments.
FIG. 3 is a schematic diagram illustrating a structure of a transformer accommodating windings in some embodiments.
FIG. 4 is a schematic diagram illustrating fixing of a conductive member by a conductive connecting member in some embodiments.
FIG. 5 is a schematic diagram illustrating a structure of a bent portion of a conductive member in some embodiments.
FIG. 6 is a schematic diagram illustrating a proportional relationship between a depth of a groove and a thickness of a first protruding member in some embodiments.
FIG. 7 is a partial enlarged view of region A in FIG. 6.
FIG. 8 is a schematic structural diagram of a positional relationship between a fixing member and a magnetic core in some embodiments.
FIG. 9 is a schematic diagram illustrating a structure of a transformer in other embodiments.
FIG. 10 is a schematic structural diagram of fixing a conductive member by a conductive connecting member in some embodiments.
FIG. 11 is a block diagram illustrating a circuit board structure in some embodiments.

Reference numerals: 10, magnetic core; 10-1, first magnetic core; 10-2, second magnetic core; 11, base; 12, first protruding member; 12-1, second protruding member; 13, first magnetic pillar; 14, second magnetic pillar; 20, conductive member; 21, bent portion; 30, conductive connecting member; 40, fixing member; 41, first bobbin; 42, second bobbin; 50, circuit board structure; 51, first circuit; 52, second circuit; 53-1, first switching device; 53-2, second switching device; S1, first surface; Q1, groove; Q2, first opening; Q3, second opening; W1, first accommodating space; W2, second accommodating space; P1, first winding; and P2, second winding.

### DETAILED DESCRIPTION OF THE EMBODIMENTS

The technical solutions in the embodiments of the present disclosure will be clearly and completely described below with reference to the accompanying drawings in the embodiments of the present disclosure. Apparently, the described embodiments are merely part of the embodiments of the present disclosure, rather than all embodiments. Based on the embodiments in the present disclosure, all other embodiments obtained by those skilled in the art without creative efforts should fall within the protection scope of the present disclosure.

In the description of the present disclosure, it should be understood that orientation or positional relationships indicated by the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential" and the like are based on the orientation or positional relationships shown in the accompanying drawings, and are merely intended to facilitate and simplify the description of the present disclosure and simplifying the description, rather than indicating or implying that the referred device or element must have a specific orientation, be constructed and operated in a specific orientation, and thus should not be construed as limiting the present disclosure.

In addition, the terms "first" and "second" are merely used for descriptive purposes, and cannot be understood as indicating or implying relative importance or implicitly indicating the number of indicated technical features. Thus, a feature defined with "first" and "second" may expressly or implicitly include one or more such features. In the description of the present disclosure, "a plurality of" means at least two, such as two, three and the like, unless otherwise expressly and specifically defined.

In the present disclosure, unless otherwise expressly specified and defined, the terms "mounted", "connected", "coupled", "fixed" and the like should be construed in a broad sense. For example, "fixed" may be a fixed connection, a detachable connection, or an integral body; "connected" or "coupled" may be a mechanical connection, or an electrical connection. It may be a direct connection, or an indirect connection via an intermediate medium, or an internal communication between two elements or an interaction relationship between two elements, unless otherwise expressly specified and defined. For those skilled in the art, the specific meanings of the above terms in the present disclosure may be understood according to specific situations.

In the present disclosure, unless otherwise expressly specified and defined, a first feature is "on" or "under" a second feature, it may mean that the first and second features are in direct contact, or the first and second features are in indirect contact through an intermediate medium. Moreover, the first feature being "on", "above" or "over" the second feature may mean that the first feature is directly above or obliquely above the second feature, or merely means that the horizontal height of the first feature is higher than that of the second feature. The first feature being "below", "under" or "beneath" the second feature may mean that the first feature is directly below or obliquely below the second feature, or merely means that the horizontal height of the first feature is lower than that of the second feature.

It should be noted that when an element is referred to as being "fixed on" or "disposed on" another element, it may be directly on the other element or there may be an intermediate element. When an element is referred to as being "connected to" another element, it may be directly connected to the other element or there may be an intermediate element. The terms "vertical", "horizontal", "upper", "lower", "left", "right" and similar expressions used herein are for illustrative purposes merely and are not meant to be the only implementations.

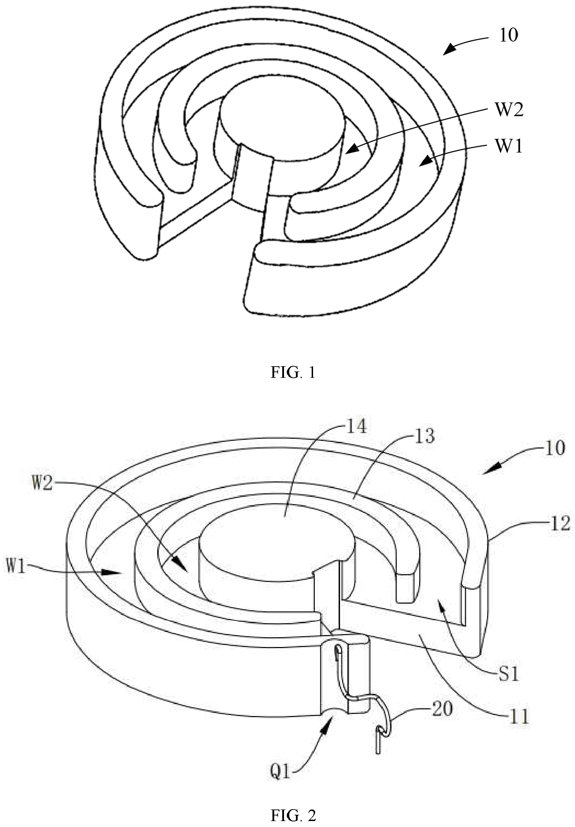

Referring to FIG. 1, FIG. 1 shows a schematic diagram of a structure of a transformer in conventional technology, which includes a magnetic core 10 and windings. Exemplarily, the magnetic core 10 may be an iron core made of a magnetic material, such as a ferrite material or a powder core material, where the powder core material may be FeSiAl, FeSi, or the like. The magnetic core 10 has a first accommodating space W1 and a second accommodating space W2 therein. In use, a primary winding and a secondary winding are respectively wound in the first accommodating space W1 and the second accommodating space W2. For example, the primary winding is disposed in the first accommodating space W1, and the secondary winding is disposed in the second accommodating space W2. When an input current passes through the primary winding, it generates a magnetic field in a center of the magnetic core. According to the principle of electromagnetic induction, the magnetic field passes through a magnetic circuit of the transformer, thereby generating an induced electromotive force in the secondary winding, and voltage transformation is achieved based on different numbers of turns of the windings.

However, during operation of the transformer, the magnetic core 10 is affected by an alternating magnetic field, causing a change in the magnetic flux inside the magnetic core 10 . The change of the magnetic flux leads to the generation of an eddy current in the magnetic core 10, thereby generating a magnetic field. The generated magnetic field causes the magnetic core to act as a signal source that radiates energy into the surrounding space. If there are other electronic devices nearby, these devices may be affected by the magnetic field and suffer from electromagnetic interference.

Based on this, in an embodiment of the present disclosure, a transformer capable of connecting the magnetic core 10 to a circuit to form a circuit loop is provided, so that current generated by electromagnetic induction flows in the circuit loop, thereby eliminating noise caused by the eddy current.

Referring to FIG. 2, FIG. 2 shows a schematic diagram of a structure of a transformer in some embodiments of the present disclosure. The transformer provided in some embodiments of the present disclosure includes a magnetic core 10 and a conductive member 20.

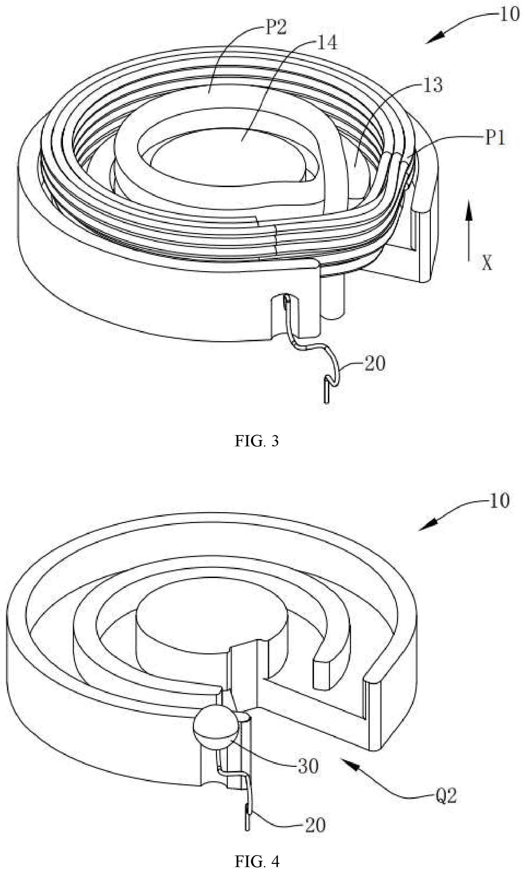

FIG. 3 shows a schematic diagram of a structure of a transformer accommodating windings in some embodiments. As shown in FIG. 3, the magnetic core 10 can be used to accommodate a first winding P1 and a second winding P2, supporting the first winding P1 and the second winding P2, maintaining geometric shapes and relative positions of the windings, and improving magnetic flux conduction efficiency between the first winding P1 and the second winding P2.

The conductive member 20 is electrically connected to the magnetic core 10. When the conductive member 20 is connected to an external circuit to form a circuit loop, a current generated in the magnetic core 10 of the transformer is introduced into the circuit loop, reducing loop impedance, thereby eliminating electromagnetic radiation from the magnetic core 10 and reducing electromagnetic interference to other electronic devices.

Continuing to refer to FIG. 2, the magnetic core 10 includes a base 11. A first protruding member 12 is disposed on a first surface S1 of the base 11, a groove Q1 is provided on an outer side of the first protruding member 12, and the conductive member 20 is at least partially located in the groove Q1 and is electrically connected to the first protruding member 12.

In these embodiments, the conductive member 20 is electrically connected to the first protruding member 12, providing an implementation method for connecting the magnetic core 10 to a circuit. When an eddy current is generated in the magnetic core 10 based on electromagnetic induction, the current can be introduced into the circuit loop via the conductive member 20 to reduce noise.

According to the transformer provided in these embodiments, the groove Q1 is provided on the first protruding member 12, the conductive member 20 is disposed in the groove Q1 and is electrically connected to the first protruding member 12. The conductive member 20 can extend for a certain distance in the groove Q1, so that the groove Q1 protects the conductive member 20 and prevents accidental collision from separating the conductive member 20 from the first protruding member 12.

Specifically, a first end of the conductive member 20 is connected to the first protruding member 12, and a second end of the conductive member 20 is connected to a target lead-out position of the current. For example, the second end may be grounded or electrically connected to another stable potential to lead out the current. Optionally, the conductive member 20 may be a needle-shaped structure or a strip-shaped structure. The needle-shaped structure refers to a structure with a pointed, slender, and elongate shape, and the strip-shaped structure refers to a structure with a long strip shape. Optionally, the conductive member may be a conductive pin, a conductive lead, a conductive wire, or the like. The needle-shaped structure and the strip-shaped structure facilitate extension and leading-out for electrical connection with a stable potential.

Referring to FIGS. 2 and 3, an embodiment in which the first winding P1 is accommodated in the first accommodating space W1 and the second winding P2 is accommodated in the second accommodating space W2 is described below. In some embodiments, a first magnetic pillar 13 and a second magnetic pillar 14 are disposed inside the first protruding member 12. The first magnetic pillar 13 is located within the first protruding member 12, and the second magnetic pillar 14 is located within the first magnetic pillar 13. Optionally, the first magnetic pillar 13 may be annular. The first accommodating space W1 is formed between the first magnetic pillar 13 and the first protruding member 12 for accommodating the first winding P1. The first winding P1 is wound in the first accommodating space W1. The second accommodating space W2 is formed between the second magnetic pillar 14 and the first magnetic pillar 13 for accommodating the second winding P2, and the second winding P2 is wound in the second accommodating space W2. Optionally, the first winding P1 may be a primary winding, and the second winding P2 may be a secondary winding. Optionally, taking the base 11 as a reference, a height of the first magnetic pillar 13 is lower than a height of the first protruding member 12, and a height difference between the first magnetic pillar 13 and the first protruding member 12 is a preset distance, so that an air gap is formed on a side of the first magnetic pillar 13 away from the base 11, and leakage inductance can be controlled through the air gap.

Optionally, the first magnetic pillar 13 may be made of a material different from the materials of the first protruding member 12 and the second magnetic pillar 14, so that the magnetic permeability of the first magnetic pillar 13 is different from the magnetic permeability of the first protruding member 12 and the second magnetic pillar 14, thereby making the magnetic field density more uniform.

Optionally, the first protruding member 12, the first magnetic pillar 13, the second magnetic pillar 14 and the base 11 are made of the same material, and a same mold can be used during manufacturing to improve the manufacturing efficiency.

As shown in FIG. 4, FIG. 4 shows a schematic diagram of fixing a conductive member 20 by a conductive connecting member 30 in some embodiments. In some exemplary embodiments, the conductive member 20 is at least partially fixed in the groove Q1 by the conductive connecting member 30.

Optionally, the conductive connecting member 30 is located at an end portion of the groove Q1, and fixes a contact area between the conductive member 20 and the first protruding member 12 at the end portion of the groove Q1, facilitating contact with other devices.

The conductive connecting member 30 has both conductive and connecting functions. Fixing the conductive member 20 by the conductive connecting member 30 can, in one aspect, improve the connection strength between the conductive member 20 and the first protruding member 12, preventing the conductive member 20 from accidentally falling off during operation of the transformer. In the other aspect, the conductive connecting member 30 can increase a conductive area between the conductive member 20 and the first protruding member 12 to improve the capacity to guide the eddy current.

Optionally, the conductive connecting member 30 may be a conductive adhesive, and the conductive adhesive is obtained by adding a conductive material to a colloid matrix. Optionally, the colloid matrix may be silica gel, polymer glue, epoxy resin, or the like, and the conductive material may be metal powder (such as silver powder, copper powder), carbon black, conductive polymer, or the like.

As shown in FIG. 4, when the conductive adhesive fixes the conductive member 20 in the groove in a wrapping manner, a wrapping structure may be formed in a contact area of the first protruding member 12. Optionally, the wrapped structure may be spherical, square, cylindrical, or other irregular shapes, as long as the conductive member 20 can be fixed, which is not limited thereto in the embodiments.

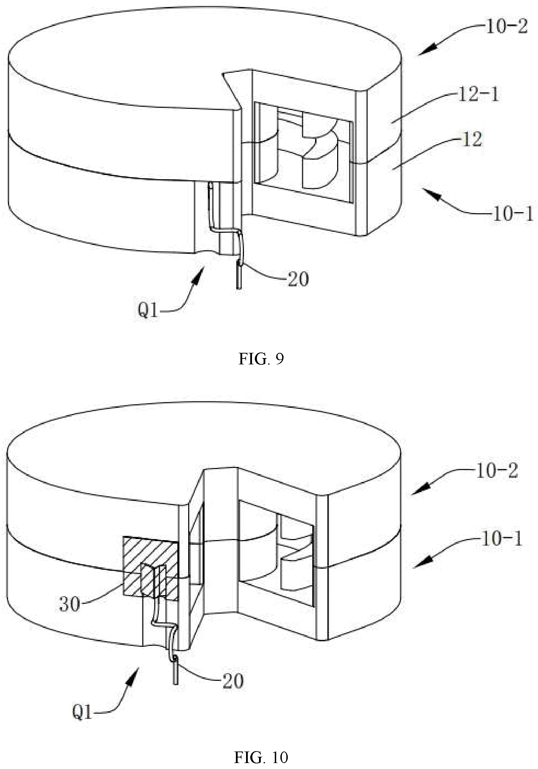

Optionally, the conductive connecting member 30 may also be a metal sheet, and the metal sheet fixes the conductive member 20 in the groove Q1 (as shown by a shaded area in FIG. 10). The metal sheet spans across the groove Q1 and is bonded to the first protruding member 12 on two sides of the groove Q1, and fixes the conductive member 20 at the position of the groove Q1.

In an implementation, the metal sheet may be bonded to the first protruding member 12 by a conductive adhesive, and also fixes the conductive member by the conductive adhesive. In other implementations, the metal sheet fixes the conductive member in a press-fit method. Optionally, the metal sheet may be made of a metal or alloy such as copper, aluminum, silver, iron, or the like. Exemplarily, the metal sheet may be a copper foil, and copper has good conductivity, which can improve a conductive effect between the conductive member 20 and the first protruding member 12.

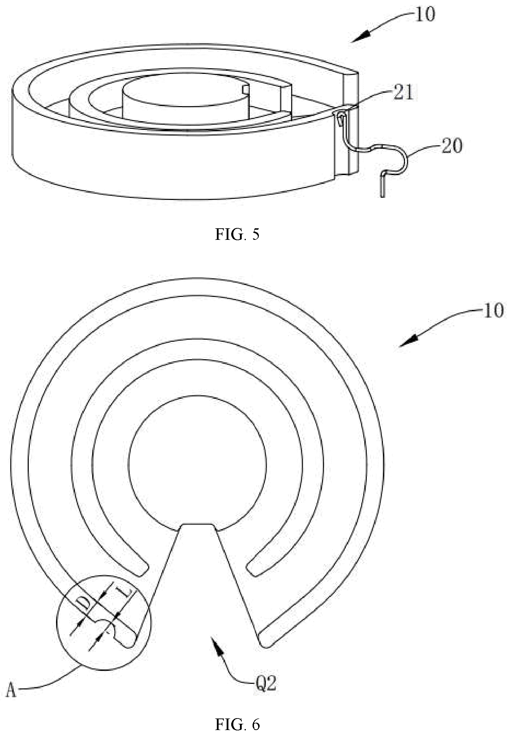

Referring to FIG. 5, FIG. 5 shows a schematic diagram of a structure of a bent portion 21 of a conductive member 20 in some embodiments. In some exemplary embodiments, the conductive member 20 has a bent portion 21, and the conductive connecting member 30 fixes the bent portion 21 of the conductive member 20 in the groove Q1. The conductive connecting member 30 fixes the bent portion 21, thereby fixing the entire conductive member 20. The bent portion 21 can increase the contact area between the conductive member 20 and the first protruding member 12 and the conductive area to improve an effect of leading out the current from the first protruding member 12.

The bent portion 21 can also prevent the conductive member 20 from falling off. For example, for a needle-shaped structure, when the adhesion of the conductive adhesive decreases, the needle-shaped structure tends to form a gap with the conductive adhesive and then separate from the conductive adhesive and fall off, forming a pinhole in the conductive adhesive. When the bent portion 21 is provided, a contact area between the conductive adhesive and the conductive member 20 is increased, thereby preventing the conductive member 20 from falling off. Moreover, even if a gap is generated, the conductive adhesive around a shank of the conductive member 20 supports the bent portion 21, thereby preventing the conductive member 20 from falling off.

In some exemplary embodiments, the groove Q1 is cylindrical or square, facilitating fixing of the conductive member 20. A cylindrical shape includes a shape with a circle or elliptical cross section, and the square shape includes a shape with a square, rectangle or other polygon cross section. Such a configuration facilitates accommodation of the conductive member 20.

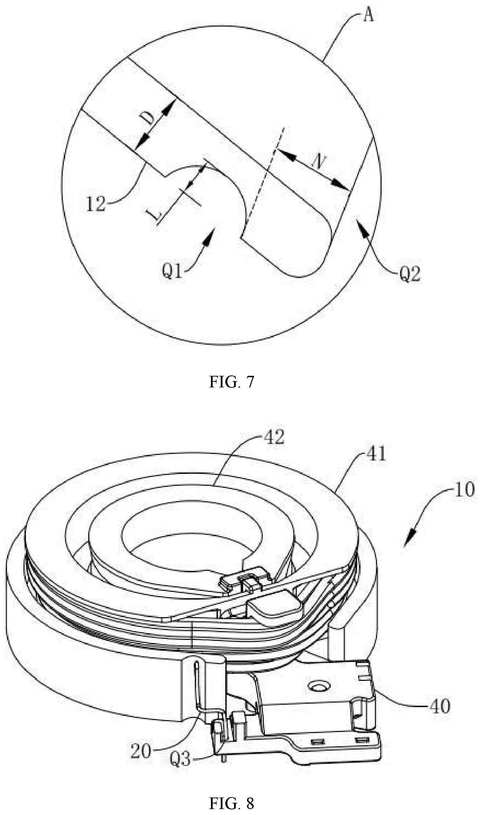

As shown in FIGS. 6 and 7, FIG. 6 shows a schematic diagram of a proportional relationship between a depth of a groove Q1 and a thickness of a first protruding member 12, and FIG. 7 shows a partial enlarged view of region A in FIG. 6. In some exemplary embodiments, in a thickness direction of the first protruding member 12, a ratio of a depth L of the groove Q1 to a thickness D of the first protruding member 12 is less than a preset ratio threshold. Optionally, the thickness direction of the first protruding member 12 is a direction parallel to the base 11. The ratio φ is equal to L/D. Optionally, the preset ratio threshold may be 0.1 to 0.5, and in this case, the depth L of the groove Q1 is less than half of the thickness D of the first protruding member 12. Optionally, the preset ratio threshold may also be 0.3.

The preset ratio threshold is configured to limit a maximum depth of the groove Q1. When the depth of the groove Q1 is too large, the first protruding member 12 is too thin at the position of the groove Q1, resulting in reduced strength and easy breakage and damage. When the ratio of the depth L of the groove Q1 to the thickness D of the first protruding member 12 is less than the preset ratio threshold, the conductive member 20 can be effectively accommodated while ensuring mechanical strength of the first protruding member 12.

Continuing to refer to FIG. 3, in some exemplary embodiments, a length of the groove Q1 in a protruding direction of the first protruding member 12 is less than a length of the first protruding member 12. Optionally, the protruding direction of the first protruding member 12 refers to the direction X in which the first protruding member 12 protrudes relative to the base 11, such as a direction perpendicular to the first surface S1. The length of the groove Q1 is less than the length of the first protruding member 12, so that the groove Q1 does not penetrate through the first protruding member 12. When the conductive member 20 is located in the groove Q1, a top of the conductive member 20 can further contact the first protruding member 12 to increase a conductive area.

In some exemplary embodiments, referring to FIG. 7, the first protruding member 12 is provided with a first opening Q2, and the groove Q1 is provided at a preset distance N from the first opening Q2. Optionally, the preset distance N may be 1 mm to 3 mm.

When the first winding P1 and the second winding P2 are accommodated inside the magnetic core 10, lead-out portions of the first winding P1 and the second winding P2 need to be led out from the magnetic core 10 to be connected to an external circuit. In this case, the lead-out portions of the first winding P1 and the second winding P2 can be led out through the first opening Q2. Optionally, both the base 11 and the first protruding member 12 are both open and communicate with each other to form the first opening Q2.

A thickness of the first protruding member 12 at the position of the groove Q1 is less than that at other positions. To prevent a region between the groove Q1 and the first opening Q2 from bending with the groove Q1 as a fold line, the groove Q1 needs to be kept at a certain distance from the first opening Q2, which can ensure strength of the first protruding member 12. Meanwhile, to facilitate electrical connection between the conductive member 20 and an external circuit, the distance between the groove Q1 and the first opening Q2 should not be too large, this makes it convenient to dispose a fixing member 40 (refer to FIG. 8) at the first opening Q2 to fix the conductive member 20.

Referring to FIG. 8, FIG. 8 shows a schematic structural diagram of a positional relationship between a fixing member 40 and a magnetic core 10 in some embodiments. In some exemplary embodiments, the transformer further includes a fixing member 40 disposed at the first opening Q2, for example, by a snap-fit manner, or by means of configuring the size of the fixing member 40 to match the first opening Q2 so as to form a fitting connection. A first part of the fixing member 40 is located inside the first protruding member 12, and a second part of the fixing member 40 is located outside the first protruding member 12. Optionally, the first part of the fixing member 40 located inside the first protruding member 12 can be configured to fix the first winding P1 and the second winding P2, maintain geometric shapes and relative positions of the first winding P1 and the second winding P2, and prevent the first winding P1 and the second winding P2 from being displaced or deformed by a magnetic field generated by the current. In some feasible implementations, the fixing member 40 includes a first bobbin 41 and a second bobbin 42. The first bobbin 41 is configured to fix the first winding P1, and the second bobbin 42 is configured to fix the second winding P2.

In some feasible implementations, the second part of the fixing member 40 is provided with a second opening Q3, and an end of the conductive member 20 passes through the second opening Q3. Optionally, the second opening Q3 may be a through hole penetrating the fixing member 40. In this case, a first end of the conductive member 20 is electrically connected to the first protruding member 12, and a second end of the conductive member 20 is fixed to the second opening Q3. Optionally, the second opening Q3 may penetrate the fixing member 40. With such a configuration, an end of the conductive member 20, after being fixed by the second opening Q3, extends out of the fixing member 40, facilitating electrical connection between the conductive member 20 and a stable potential.

Referring to FIG. 9, FIG. 9 shows a schematic diagram of a structure of a transformer in other embodiments. In the present disclosure, a transformer is further provided, including a first magnetic core 10-1, a second magnetic core 10-2 and a conductive member 20. A through groove Q1 is provided on an outer side of a first protruding member 12 of the first magnetic core 10-1, and the conductive member 20 is at least partially located in the through groove Q1 and abuts against a second protruding member 12-1 of the second magnetic core 10-2. Optionally, a bent portion of the conductive member 20 is located in the through groove Q1 and abuts against the second protruding member 12-1. The through groove Q1 facilitates processing, improving processing efficiency and reducing processing cost.

Optionally, the first magnetic core 10-1 and the second magnetic core 10-2 are disposed opposite to each other and bonded together. The first protruding member 12 of the first magnetic core 10-1 and the second protruding member 12-1 of the second magnetic core 10-2 are disposed opposite to each other to form interior accommodating spaces for the first winding P1 and the second winding P2 therebetween. In some embodiments, the first magnetic core 10-1 and the second magnetic core 10-2 are identical and symmetrically bonded together. With such a configuration, only one mold is required in the manufacturing process, improving manufacturing efficiency and reducing mold opening cost.

Referring to FIG. 10, FIG. 10 shows a schematic structural diagram of fixing a conductive member 20 by a conductive connecting member 30 in some embodiments. In some exemplary embodiments, the conductive member 20 is at least partially fixed in the groove Q1 by the conductive connecting member 30, and the conductive connecting member 30 bridges across the first magnetic core 10-1 and the second magnetic core 10-2.

Optionally, the conductive connecting member 30 may also be a metal sheet. As shown by a shaded area in FIG. 10, the metal sheet fixes the conductive member 20 in the groove Q1. The metal sheet is connected to both the first magnetic core 10-1 and the second magnetic core 10-2 to electrically connect the first magnetic core 10-1 and the second magnetic core 10-2, and further fixes the conductive member 20 at the position of the groove Q1.

Optionally, the conductive connecting member 30 may also be a conductive adhesive, and the conductive adhesive bonds the conductive member, as well as the first magnetic core 10-1 and the second magnetic core 10-2, so that the first magnetic core 10-1 and the second magnetic core 10-2 are electrically connected.

The conductive connecting member 30 can electrically connect the first magnetic core 10-1 and the second magnetic core 10-2, so that when a current is generated in either or both of the first magnetic core 10-1 and the second magnetic core 10-2 based on electromagnetic induction, the current can be led out from the conductive member 20.

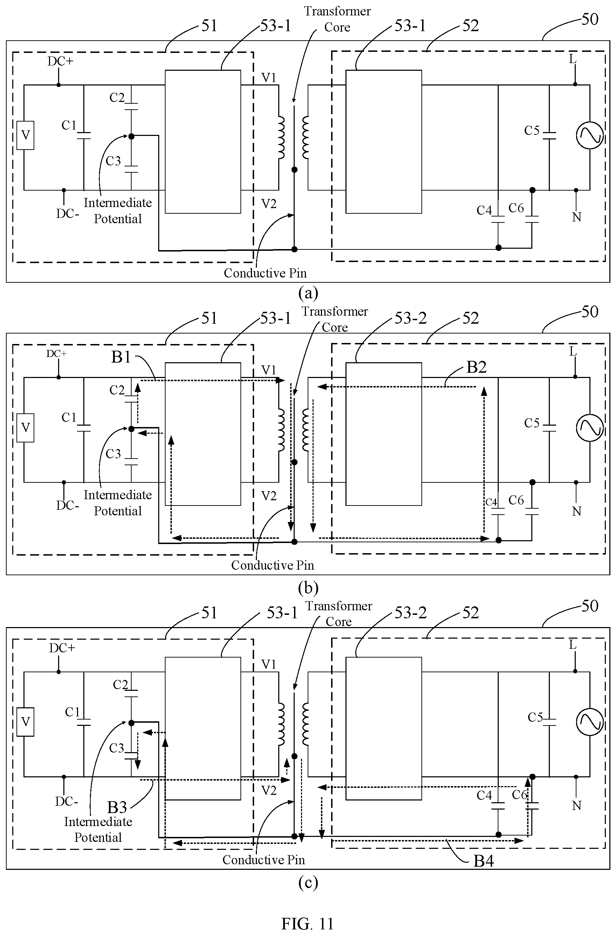

Referring to FIG. 11, FIG. 11 shows a block diagram of a circuit board structure 50 in some embodiments. In the present disclosure, a circuit board structure 50 is further provided, including a circuit board and a transformer. The circuit board is provided with a first circuit 51 and a second circuit 52, and either or both of the first circuit 51 and the second circuit 52 include a switching device. The transformer is disposed on the circuit board and connected to the circuit board via a second surface. A first accommodating space W1 and a second accommodating space W2 are provided inside the first protruding member 12. The first accommodating space W1 is provided with a first winding P1, and the second accommodating space W2 is provided with a second winding P2. The first winding P1 is electrically connected to the first circuit 51, the second winding P2 is electrically connected to the second circuit 52, and the conductive member 20 is electrically connected to a stable potential of the circuit board.

Optionally, the switching device may be a switching transistor controlled by pulse width modulation (PWM), such as a metal-oxide-semiconductor field-effect transistor (MOSFET). A plurality of switching devices form a rectifier module, a filter module or an inverter module. When a PWM signal controls a MOS transistor, rapid switching of the PWM signal causes a rapid change in the current, thereby generating a magnetic field. When the circuit structure includes a switching device, an eddy current is generated in the magnetic core 10 of the transformer based on the principle of electromagnetic induction, thereby generating noise. Therefore, the magnetic core needs to be grounded to reduce impedance.

In these embodiments, by electrically connecting the conductive member 20 to the stable potential on the circuit board, similar to a wire connecting the magnetic core 10 to the stable potential, a low-impedance loop is formed, so that the magnetic core 10 is no longer a floating conductor, and the voltage and current signals generated after coupling electromagnetic waves can be led away through the low-impedance loop, thereby reducing noise.

In some feasible implementations, the stable potential is a ground potential on the circuit board. Optionally, the ground potential may be a potential connected to a ground wire, or a virtual ground potential formed by the circuit board. The virtual ground potential refers to a ground point simulated in a circuit, which is not actually directly connected to the ground, but is regarded as a ground potential in circuit design and analysis.

In other feasible implementations, as shown in (a) of FIG. 11, the first circuit includes a DC power supply, a first capacitor C1, a second capacitor C2, a third capacitor C3, a first switching device 53-1 and a first inductor. The second circuit includes a second inductor, a second switching device 53-2, a fourth capacitor C4, a fifth capacitor C5 and a sixth capacitor C6.

The stable potential may be any one of the following (1) to (5): (1) a positive terminal of the power supply in the first circuit 51 (DC+ shown in FIG. 11); (2) a negative terminal of the power supply in the first circuit 51 (DC- shown in FIG. 11); (3) a neutral wire in the second circuit 52 (N shown in FIG. 11); (4) a live wire in the second circuit 52 (L shown in FIG. 11); and (5) an intermediate potential formed by interconnecting filter capacitors in the first circuit 51 or the second circuit 52.

Optionally, as shown in (b) of FIG. 11, noise loops B1 and B2 can be formed, where the intermediate potential is located between the second capacitor C2 and the third capacitor C3, the noise loop B1 is formed in the first circuit, specifically between the second capacitor C2 and the transformer, and the noise loop B2 is formed in the second circuit, specifically between the fourth capacitor C4 and the transformer. As shown in (c) of FIG. 11, noise loops B3 and B4 can also be formed, the noise loop B3 is formed in the first circuit, specifically between the third capacitor C3 and the transformer, and the noise loop B4 is formed in the second circuit, specifically between the sixth capacitor C6 and the transformer.

In addition, according to the definition formula of common-mode noise: common-mode noise is denoted as (V1+V2)/2, it is obtained that the common-mode noise is balanced. Connecting the conductive member to the intermediate potential as shown in FIG. 11 can well balance the common-mode noise by taking the intermediate potential as a balance point.

The circuit board structure 50 provided in the embodiment includes a switching device. A rapid change of the switching device causes a rapid change in the current, thereby generating a magnetic field. When the circuit structure includes a switching device, an eddy current is generated in the magnetic core 10 of the transformer based on the principle of electromagnetic induction. By connecting the magnetic core 10 to the stable potential through the conductive member 20, the conductive member 20 can serve as a wire to form a loop between the magnetic core 10 and the stable potential, so that the current generated in the magnetic core 10 of the transformer based on the electromagnetic induction is introduced into the circuit loop instead of existing in the form of eddy current, thereby eliminating electromagnetic radiation from the magnetic core 10, reducing electromagnetic interference to other electronic devices, and eliminating noise.

The technical features of the above embodiments may be combined arbitrarily. To simplify the description, not all possible combinations of the technical features in the above embodiments are described. However, as long as there is no contradiction in the combination of these technical features, they should be considered as falling within the scope recorded in the specification.

The above embodiments only describe several embodiments of the present disclosure, and the description is relatively specific and detailed, but cannot be construed as limiting the patent scope of the present disclosure. It should be noted that those skilled in the art may make several modifications and improvements without departing from the concept of the present disclosure, and these modifications and improvements all fall within the protection scope of the present disclosure. Therefore, the patent protection scope of the present disclosure should be subject to the appended claims.

## Claims

1. A transformer, comprising a magnetic core and a conductive member, wherein:
the magnetic core comprises a base, a first protruding member being disposed on a first surface of the base, and a groove being provided on an outer side of the first protruding member; and
the conductive member is at least partially located in the groove and is electrically connected to the first protruding member.

2. The transformer according to claim 1, wherein the conductive member is at least partially fixed in the groove by a conductive connecting member.

3. The transformer according to claim 2, wherein the conductive member has a bent portion, and a position of the conductive connecting member corresponds to the bent portion of the conductive member.

4. The transformer according to claim 2, wherein the conductive connecting member is located at an end portion of the groove.

5. The transformer according to claim 2, wherein the conductive connecting member is a metal sheet, and the conductive member is fixed in the groove by the metal sheet.

6. The transformer according to any one of claims 1 to 4, wherein the groove is cylindrical or square.

7. The transformer according to any one of claims 1 to 4, wherein in a thickness direction of the first protruding member, a ratio of a depth of the groove to a thickness of the first protruding member is less than a preset ratio threshold.

8. The transformer according to any one of claims 1 to 4, wherein a length of the groove in a protruding direction of the first protruding member is less than a length of the first protruding member.

9. The transformer according to any one of claims 1 to 4, wherein the first protruding member is provided with a first opening, and the groove is provided at a preset distance from the first opening.

10. The transformer according to claim 9, wherein the transformer further comprises:
a fixing member disposed at the first opening, a first part of the fixing member being located inside the first protruding member, and a second part of the fixing member being located outside the first protruding member.

11. The transformer according to claim 10, wherein the second part of the fixing member is provided with a second opening, and an end of the conductive member passes through the second opening.

12. A transformer, comprising a first magnetic core, a second magnetic core and a conductive member, wherein
a through groove is provided on an outer side of a first protruding member of the first magnetic core, and the conductive member is at least partially located in the through groove and abuts against a second protruding member of the second magnetic core.

13. The transformer according to claim 12, wherein the conductive member is at least partially fixed in the groove by a conductive connecting member, and the conductive connecting member bridges across the first magnetic core and the second magnetic core.

14. A circuit board structure, comprising:
a circuit board provided with a first circuit and a second circuit, wherein either or both of the first circuit and the second circuit comprise a switching device; and
the transformer according to any one of claims 1 to 11, disposed on the circuit board, wherein a first accommodating space and a second accommodating space are provided inside the first protruding member, the first accommodating space is provided with a first winding, the second accommodating space is provided with a second winding, the first winding is electrically connected to the first circuit, the second winding is electrically connected to the second circuit, and the conductive member is electrically connected to a stable potential of the circuit board.

15. The circuit board structure according to claim 14, wherein the stable potential is a ground potential on the circuit board.

16. The circuit board structure according to claim 14, wherein the stable potential is any one of:
a positive terminal or a negative terminal of a power supply in the first circuit;
a neutral wire or a live wire in the second circuit; and
an intermediate potential formed by interconnecting filter capacitors in the first circuit or the second circuit.
